# EUROPÄISCHE PATENTSCHRIFT

(11) **EP 2 452 365 B1**
(45) Veröffentlichungstag und Bekanntmachung des Hinweises auf die Patenterteilung: **02.11.2016**
(21) Anmeldenummer: 10726990.4
(22) Anmeldetag: 01.07.2010
(51) Int. Cl.: H01L 31/042

(54) **PHOTOVOLTAIK-MODUL UND PHOTOVOLTAIK-EINRICHTUNG**
PHOTOVOLTAIC MODULE AND PHOTOVOLTAIC DEVICE
MODULE PHOTOVOLTAÏQUE ET DISPOSITIF PHOTOVOLTAÏQUE

(30) Priorität: 06.07.2009 DE 102009031982
(43) Veröffentlichungstag der Anmeldung: 16.05.2012
(73) Patentinhaber: Fraunhofer Gesellschaft zur Förderung der angewandten Forschung e.V., 80686 München (DE)
(72) Erfinder: LAUINGER, Thomas, 63843 Niedernberg (DE)
(86) Internationale Anmeldenummer: PCT/EP2010/059407
(87) Internationale Veröffentlichungsnummer: WO 2011/003810

(56) Entgegenhaltungen:
- DE-A1- 3 606 464
- DE-A1- 10 054 776
- DE-A1- 10 317 020
- JP-A- 2 297 976
- JP-A- 60 189 272
- US-A- 4 401 839
- US-A- 5 542 988
- US-A- 6 093 884

## Beschreibung

Die Erfindung betrifft ein Photovoltaik-Modul nach dem Oberbegriff des Anspruchs 1 sowie eine Photovoltaik-Einrichtung mit mehreren solcher Photovoltaik-Module nach dem Oberbegriff des nebengeordneten Anspruchs. Insbesondere betrifft die Erfindung ein Photovoltaik-Modul zum Einbau in und Aufbau von Photovoltaik-Einrichtungen, die für eine Stromversorgung von Verbrauchern über eine Hochspannungs-Gleichstromübertragungsstrecke, geeignet sind, wobei sich die Verbraucher in weiter oder auch naher Entfernung zur jeweiligen Photovoltaik-Einrichtung befinden können.

Photovoltaik-Einrichtungen bzw. -Anlagen kommen zunehmend zum Einsatz in sogenannten Photovoltaik-Kraftwerken, die vornehmlich in sonnenreichen Regionen installiert werden und zentral Strom für die vorhandenen und häufig weit entfernten verbraucherseitigen Stromversorgungsnetze erzeugen sollen. Solche Photovoltaik-Einrichtungen werden bevorzugt großflächig angelegt und beispielsweise in Wüstengebieten installiert, um maßgeblich einen Beitrag zur Stromgewinnung aus Solarenergie zu leisten. Diese Anlagen werden auch als "Very Large Scale Photovoltaic Systems", kurz VLS-PV-Systeme, bezeichnet und beispielsweise in dem Artikel "Very Large Scale PV-Systems" von Dr. Rudolf Minder in dem Themenheft "FVS-Themen 2002" auf den Seiten 67 bis 70 vorgestellt (Veröffentlichung vom Forschungsverbund Sonnenenergie, Berlin, Deutschland, im Internet unter der URL: www.fv-sonnenenergie.de). Dort wird ein modularer Aufbau mehrerer PV-Module vorgeschlagen, wobei dieser nicht näher beschrieben wird. Zur Übertragung der gewonnenen Elektrizität werden verschiedene Transport-Techniken, u.a. auch die Hochspannungs-Gleichstrom-Überträgung, kurz HGÜ genannt, vorgeschlagen.

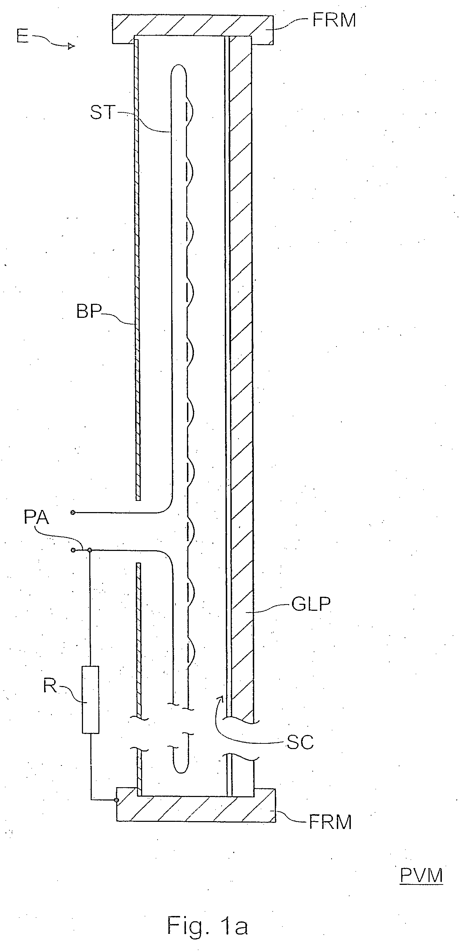

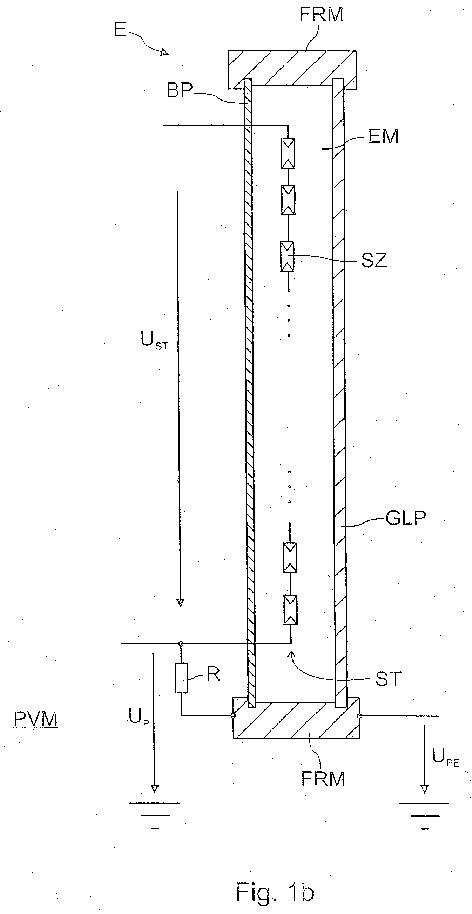

In der DE 100 54 776 A1 wird eine Photovoltaik-Einrichtung in für den Einsatz in der Raumfahrt offenbart. Die Einrichtung umfasst ein Photovoltaik-Modul, das mindestens einen Solarzellen-String aufweist, der jeweils aus einer Anzahl von in Reihe verschalteter Solarzellen besteht, wobei der Solarzellen-String in einer aus mehreren Modulteilen (siehe dort in Fig. 1: Deckgläser 1, Trägermaterial 6) gebildeten Einfassung aufgenommen ist, wobei die Modulteile elektrisch leitend ausgebildet und miteinander verbunden sind, so dass die Einfassung eine elektrostatisch wirksame Umhüllung des mindestens einen Solarzellen-Strings darstellt. Die Einfassung mit mindestens einem Kontaktelement in zur Potentialanbindung der elektrostatisch wirksamen Umhüllung an mindestens ein definiertes elektrisches Potential (Potential des Raumfahrzeuges) versehen, wobei das mindestens eine Kontaktelement aus einem hochohmig leitenden Material (leitender Kleber 3) mit einem Mindestflächenwiderstand von 10⁹ Ohm/cm² gefertigt ist.

Aus der DE 103 17 020 A1 ist ein photovoltaisches Modul mit mindestens einer Solarzelleneinheit bekannt, die mit einer die Solarzelleneinheit abdeckenden Schutzlage versehen ist. Das Modul weist einen Modulrahmen aus Kunststoff auf und eine elektrische Anschlusseinheit zur elektrischen Verschaltung der mindestens einen Solarzelleneinheit sowie mit einer elektrischen Kupplungseinheit zur elektrischen Verbindung des Moduls mit einem weiteren Modul, einem Energiespeicher oder einer Verbrauchereinheit, wobei die elektrische Kupplungseinheit in den Modulrahmen integriert ist.

Aus der JP 2 297 976 A ist ein Photovoltaik-Modul zum Einbau in eine Photovoltaik-Einrichtung bekannt. Das Moduls weist mindestens einen Solarzellen-String aufweist, der jeweils aus einer Anzahl von. in Reihe verschalteter Solarzellen besteht. Der Solarzellen-String ist in einer in einer aus mehreren Modulteilen gebildeten Einfassung aufgenommen ist, wobei die Modulteile elektrisch leitend ausgebildet und miteinander verbunden sind, so dass die Einfassung eine elektrostatisch wirksame Umhüllung des mindestens einen Solarzellen-Strings darstellt. Die Einfassung ist mit mindestens einem Kontaktelement versehen, das zur Potentialanbindung der elektrostatisch wirksamen Umhüllung an ein definiertes elektrisches Potential, nämlich Erdungspotential, dient.

Die US 4 401 839 A offenbart auch ein derartiges Photovoltaik-Modul.

Weitere Photovoltaik-Module werden in DE 39 35 826 A1, US 5 542 988 A und US 2006/0196 535 A1 beschrieben.

Eine besonders effizient wirkende Stromversorgung mittels einer aus Photovoltaik-Modulen aufgebauten Photovoltaik-Einrichtung bzw. -Anlage wird in der früheren Anmeldung DE 10 2009 004 679 vorgeschlagen. Dort werden mehrere Photovoltaik-Module (PV-Module) zur Erzeugung einer Gleichspannung in Parallel- und/oder Reihenschaltung miteinander verschaltet, so dass die erzeugte Gleichspannung für eine Hochspannungs-Gleichstrom-Übertragung (HGÜ) geeignet ist. Jedes PV-Modul weist mehrere Modulteile auf, die eine Einfassung für die mehreren Solarzellen-Strings bilden. Zu den Modulteilen gehören, ein Rahmen, eine vordere Glasscheibe und eine Rückwand. Durch die Verschaltung mehrerer Solarzellen-Strings können in einem einzelnen Modul bereits etwa 70-220 Volt erzeugt werden. Durch die anschließende Verschaltung von mehreren PV-Modulen zu Blöcken und Strängen können Gleichspannungen im Hochspannungs-Bereich von mehreren Tausend Volt und darüber hinaus gehend erzeugt werden. Somit kann bereits erzeugerseitig am Ort der Photovoltaik-Einrichtung eine ausreichend hohe Gleichspannung erzeugt werden, die dann direkt in eine HGÜ-Strecke eingespeist und zur Verbraucherseite hin übertragen werden kann. Am Ende der HGÜ-Strecke ist lediglich eine Umsetzung von der übertragenen Gleichspannung in eine gewünschte Wechselspannung erforderlich. Aufgrund der Verschaltung der PV-Module kann die von der Photovoltaik-Einrichtung erzeugte Gleichspannung die Spannungsfestigkeit der einzelnen PV-Module, welche gegenwärtig bei etwa max. 1 kV liegt, um ein Vielfaches übersteigen und z.B. in einem Hochspannungs-Bereich von 1 kV bis 2 MV liegen.

Die mit der dort vorgeschlagenen Technik erzeugten Gleichspannungen überschreiten schnell die üblichen Spannungsfestigkeiten von etwa 1kV. Dies ist insbesondere bei einer isolierten Aufständerung der PV-Module bzw. PV-Blöcke möglich, weil dann keine Überschläge zwischen den eingebetteten Solarzellenstrings und der Einfassung bzw. Moduleinkapselung (bestehend aus Frontglas, Rückseitenfolie oder Rückseitenglas und Rahmen) auftreten können. Deshalb sollten Maßnahmen getroffen werden, die verhindern, dass aufgrund der hohen Spannungspotentiale Feldeffekte auftreten, welche negative Auswirkungen auf die Funktion der Solarzellen haben können und evtl. sogar das Einkapselungsmaterial schädigen können oder zu Koronaentladungen und damit zu nicht vernachlässigbaren Leistungsverlusten führen können. Es ist daher wünschenswert eine Modul-Konstruktion zu schaffen, die die Reihenschaltung von einer großen Vielzahl von Modulen erlaubt, ohne dass ein Problem durch das Auftreten sehr hoher Spannungspotentiale auftritt. Die neue Konstruktion soll auch besonders gut für eine Verschaltung mehrerer PV-Module zu Blocken und/oder Strängen geeignet sein.

Daher ist es Aufgabe der vorliegenden Erfindung, ein Photovoltaik-Modul der eingangs genannten Art so zu verbessern, dass die genannten Nachteile überwunden werden. Insbesondere soll das verbesserte Photovoltaik-Modul für die Verwendung in langen Reihenschaltungen mit Strangspannungen im Bereich von 2 kV bis 2 MV geeignet sein. Außerdem soll eine Photovoltaik-Einrichtung vorgeschlagen werden, die insbesondere für die direkte Einspeisung der erzeugten Spannung in eine HGÜ-Strecke geeignet ist.

Gelöst wird die oben genannte Aufgabe durch ein Photovoltaik-Modul mit den Merkmalen des Anspruchs 1 sowie durch eine Photovoltaik-Einrichtung mit den Merkmalen des nebengeordneten Anspruchs.

Demnach wird vorgeschlagen, dass das mindestens eine Kontaktelement, welches zur Potentialanbindung der elektrostatisch wirksamen Umhüllung an mindestens ein definiertes elektrisches Potential dient, als ein hochohmig leitendes Element mit einem Mindestwiderstand von 10⁶ Ohm ausgebildet ist und/oder aus einem hochohmig leitenden Material mit einem Mindestflächenwiderstand von 10⁹ Ohm/cm² gefertigt ist, wobei der Rahmen des Photovoltaik-Moduls eine abgerundete Formgebung aufweist, die asymmetrisch zum Photovoltaik-Modul ausgebildet ist.

Dadurch wird nicht nur erreicht, dass die Potentialanbindung hochohmig ist (im Mega-Ohm- oder Giga-Ohm-Bereich oder höher) und nur sehr geringe Potential-Ausgleichsströme (im Mikro-Ampere-Bereich oder geringer) fließen können, sondern dass durch die abgerundete Formgebung des leitenden Rahmens auch Korona-Entladungen vermieden werden, wobei durch die asymmetrische eine Abschattung der Modulfläche vermieden wird.

Die Einfassung ist als eine elektrostatisch wirksame Umhüllung ausgebildet und mit mindestens einer Kontaktierungsmöglichkeit, wodurch die Möglichkeit besteht, die Umhüllung auf ein definiertes elektrisches Potential zu legen, z.B. auf das Potential eines Anschlusspunktes des Solarzellen-Strings, also etwa auf das Potential am Anfang, am Ende oder auch in der Mitte der Reihenschaltung der Solarzellen. Dies kann z.B. durch einen hochohmigen.diskreten Widerstand realisiert werden. Auch kann die mindestens eine Kontaktierungsmöglichkeit durch ein hochohmiges Einbettungs- bzw. Füllmaterial realisiert werden, das das Innere der Einfassung ausfüllt und somit die Solarzellen bzw. den String hochohmig einbettet und mit der leitenden Einfassung in Kontakt bringt. Durch diese und ähnliche Ausgestaltungen von Kontaktelementen ergibt sich eine definierte Potentialanbindung der Einfassung und insbesondere ein hochohmiger Potentialausgleich zwischen Solarzellen-String und Einfassung.

In einer bevorzugten Ausgestaltung der Erfindung ist das mindestens eine Kontaktelement als ein zumindest hochohmig leitender Kontaktpunkt ausgebildet, der an einem der Modulteile angeordnet ist. Über diesen von Außen zugänglichen Kontaktpunkt bzw. Anschlusspunkt kann mittels eines leitenden Elementes die Einfassung auf ein gewünschtes Potential (z.B. das mittlere Potenzial einer Modulgruppe, mit einer maximalen Spannungsdifferenz von +/- 1000 Volt zum Potential des Solarzellenstrings im Inneren des Moduls) gelegt werden.

Beilspielsweise ist das mindestens eine Kontaktelement als hochohmig leitender Widerstand ausgebildet. Dies kann ein diskretes Bauteil sein, das zwischen einem Kontaktpunkt am Solarzellen-String und der Einfassung, insbesondere dem Rahmen, angeordnet ist.

Auch kann zur Kontaktierungsmöglichkeit und für den Potentialausgleich, vorgesehen sein, dass das hochohmig leitende Material als ein in die Einfassung eingebrachtes Einbettungsmaterial ausgebildet ist, wobei der mindestens eine Solarzellen-String innerhalb der Einfassung in dem Einbettungsmaterial aufgenommen ist. Demnach ist das mindestens eine Kontaktelement in Gestalt eines hochohmig leitenden Einbettmaterials ausgebildet, das in den Innenraum der Einfassung eingebracht ist und einen Potentialausgleich zwischen Solarzellen-String und Einfassung (Rahmen, Front- und Rückseite) herstellt. Beispielsweise kann das Einbettmaterial durch zwei vor der Montage des Moduls eingelegte Folien gebildet werden, die zum Schmelzen und/oder Aufschäumen gebracht werden und somit den Solarzellen-String einbetten.

Die Einfassung ist bevorzugt so gestaltet, dass eines der Modulteile der Rahmen selbst sein kann, der aus einem leitfähigen Material, insbesondere Metall, gefertigt und/oder mit mindestens einem Element versehen ist, das elektrisch leitend ist. Ein anderes Modulteil kann die Rückwand sein, die aus einem leitfähigen Material gefertigt und/oder mit mindestens einem Element versehen ist, das elektrisch leitend ist. Als weiteres kann eine Glasscheibe verwendet werden, die aus einem leitfähigen Material gefertigt und/oder mit mindestens einem Element versehen ist, das elektrisch leitend ist.

Insgesamt ergibt sich somit für jedes PV-Modul eine elektrisch zumindest hochohmig leitende Einfassung, die den mindestens einen Solarzellen-String umhüllt und auf das näherungsweise gleiche elektrische Potential des Solarzellen-Strings gelegt werden kann und dann dafür sorgt, dass keine hohen Feldstärken mehr im Innern des Moduls auftreten können. Das elektrische Potential des Solarzellenstring kann eine max. Differenz aufweisen, die der Modulspannüngsfestigkeit entspricht, welche wiederum typischer Weise etwa 1 Kilovolt beträgt. Um die Einfassung als elektrostatisch wirksame Umhüllung zu gestalten, kann insbesondere bei der Glasscheibe die hochohmige Leitfähigkeit auch durch eine Beschichtung bzw. Bedampfung erzielt werden, wobei es nicht erforderlich ist, alle Bereiche der Glassscheibe leitend auszubilden. Es kann ausreichen, ein Gitter oder eine Linienstruktur mit leitenden Beschichtungslinien aufzudampfen. Die Beschichtung kann auf der Glasinnen- oder Glasaußenfläche angebracht sein. Auch kann vorgesehen sein, das Glasmaterial selbst mit leitenden Elementen bzw. Partikeln zu versehen.

Die elektrische Kontaktierungsmöglichkeit der Einfasssung kann auch durch die Verwendung eines elektrisch leitfähigen Rahmens realisiert werden, der z.B. durch Anschrauben an eine elektrisch leitfähige Aufständerung kontaktiert werden kann. Alternativ können elektrische Kabelanschlußpunkte am Rahmen oder an der Modulrückseite vorgesehen werden.

Diese und weitere Vorteile ergeben sich auch aus den Unteransprüchen Eine bevorzugte Ausgestaltung kann dadurch erreicht werden, dass der mindestens eine Solarzellen-String innerhalb der Einfassung in einem hochohmig leitenden Einbettungsmaterial aufgenommen ist. Dadurch findet immer einer hochohmiger (und somit auch verlustarmer) Potentialausgleich zwischen Solarzellen-String(s) und Einfassung statt, der dafür sorgt, dass der Rahmen des jeweiligen PV-Moduls das Potentialniveau des Solarzellen-Strings annimmt. Dies ist erforderlich, falls die Einfassung nicht extern durch elektrisch leitfähigen Kontakt mit einer elektrisch leitfähigen Aufständerung auf ein definiertes elektrisches Potential festgelegt werden kann, weil beispielsweise eine elektrisch isolierende Aufständerung, z.B. aus Holz, Verwendung findet.

Das kann alternativ auch dadurch erreicht werden, indem der mindestens eine Solarzellen-String über einen hochohmigen diskreten Widerstand mit der Einfassung, insbesondere mit dem Rahmen, elektrisch verbunden ist.

Die Erfindung und die sich daraus ergebenden Vorteile werden nachfolgend anhand von Ausführungsbeispielen und unter Bezugnahme auf die beilegenden Zeichnungen näher beschrieben, wobei:
- Fig. 1a: in schematischer Querschnittsansicht den Aufbau eines ersten erfindungsgemäßen Photovoltaik-Moduls (PV-Moduls) zeigt;
- Fig. 1b: das PV-Modul nach Fig. 1a zeigt, wobei der mindestens eine Solar-Zellenstring in Form eines Ersatzschaltbildes dargestellt ist;
- Fig. 2a: in schematischer Querschnittsansicht den Aufbau eines zweiten erfindungsgemäßen Photovoltaik-Moduls (PV-Moduls) zeigt;
- Fig. 2b: das PV-Modul nach Fig. 2a zeigt, wobei der mindestens eine Solar-Zellenstring sowie die hochohmigen Elemente in Form eines Ersatzschaltbildes dargestellt sind;
- Fig. 3: in einer Teilansicht die erfindungsgemäße Gestaltungen des PV-Modul-Rahmens darstellt; und
- Fig. 4a,b: den schematischen Aufbau eines aus mehreren PV-Modulen aufgebauten PV-Strangs als Teil einer PV-Einrichtung veranschaulicht.

Die Figur 1a zeigt in einer Querschnittsansicht den Aufbau eines erfindungsgemäßen Photovoltaik-Moduls (PV-Moduls) in einer ersten Ausführungsform, wobei das Modul PVM in der Darstellung senkrecht aufgerichtet ist. In der montierten Stellung wäre das Modul schräg ausgerichtet, so dass die Frontseite bzw. Oberseite (hier die rechte Seite) des Moduls möglichst senkrecht zur Sonneneinstrahlung orientiert ist. Das Modul PVM besteht im wesentlichen aus einem öder mehreren Solarzellen-Strings ST, die im Innern des Moduls angeordnet sind und von denen hier exemplarisch ein String dargestellt ist. Außerdem befinden sich auf der Ober- bzw. Vorderseite des Moduls PVM eine Glasscheibe GLP und auf der Unter- bzw. Rückseite (hier linke Seite) eine Rückwand BP, die hier z.B. aus Metall gefertigt ist, die aber z.B. auch eine Rückseitenfolie oder eine Glasplatte sein kann. Die beschriebene Anordnung wird von einem Rahmen FRM eingefasst, der hier ebenfalls aus Metall gefertigt ist. Der Rahmen, die Glasscheibe sowie die Rückseite sind Modulteile, die eine Einfassung bzw. Einkapselung für das mindestens eine Solarzellen-String ST ausbilden.

Werden nun viele Module in Reihe geschaltet, um die erzeugte Spannung zu erhöhen, und werden die Module isoliert aufgeständert (s. auch Fig. 9a,b), um ein Überschreiten der üblichen Modulspannungsfestigkeit zu ermöglichen, so können auch sehr hohe Feldstärken an den Strings ST: gegenüber der Umgebung auftreten. Dabei kann es zu einer Beeinträchtigung der Solarzellenfunktion und sogar zu Schädigungen des Einbettmaterials kommen.

Um dies zu vermeiden, ist die in der Fig. 1a gezeigte Einfassung bestehend aus Rahmen FRM, Glasscheibe GLP und Rückwand BP elektrisch leitend ausgebildet und zwar zumindest hochohmig leitend, so dass die gesamte Einfassung auf ein definierbares Potential gelegt werden kann. Dazu ist mindestens ein Kontaktelement vorgesehen. Beispielsweise kann dies durch ein weiteres hochohmige Element, wie hier durch den gezeigten Widerstand R von z.B. 5 GΩ, erreicht werden, das bzw. der den inneren String ST mit der Einfassung verbindet und somit einen Potentialausgleich schafft. Es reicht aus, wenn der Widerstand R eine Stelle des Strings ST, beispielsweise einen der Anschlüsse, mit einem Modulteil der Einfassung, beispielsweise dem Rahmen FRM, hochohmig leitend verbindet.

Die Fig. 1b zeigt ein zur Fig. 1a passendes Ersatzschaltbild. Der Solarzellen-String ST umfasst mehrere in Reihe geschaltete Solarzellen SZ, die insgesamt eine Strangspannung U_{ST} erzeugen. Durch Reihenschaltung vieler Module und isolierte Aufständerung der Module, kann sich zwischen einem String ST und der Umgebung (Erdpotential) eine sehr hohe Potentialdifferenz Up von mehreren Kilovolt oder gar Megavolt ergeben. Es treten also Spannungen auf, die die Spannungsfestigkeit eines einzelnen Moduls bei weitem übersteigen können und damit auch hohe Feldstärken, für die herkömmliche Module nach dem Stand der Technik nicht ausgelegt sind.

Durch einen an jedem Modul vorgesehenen diskreten Widerstand R findet ein Potentialausgleich zwischen dem jeweiligen String ST und der jeweiligen Einfassung bzw. dem Rahmen FRM statt, so dass das Potential Up zwischen Stringanfang und Erde gleichgroß ist, wie das Potential zwischen Einfassung und Erde. Mit anderen Worten: Die Einfassung liegt auf dem Potential des Stringanfangs, so dass zwischen Einfassung und den Solarzellen des Strings maximal die Strangspannung Ust auftreten kann.

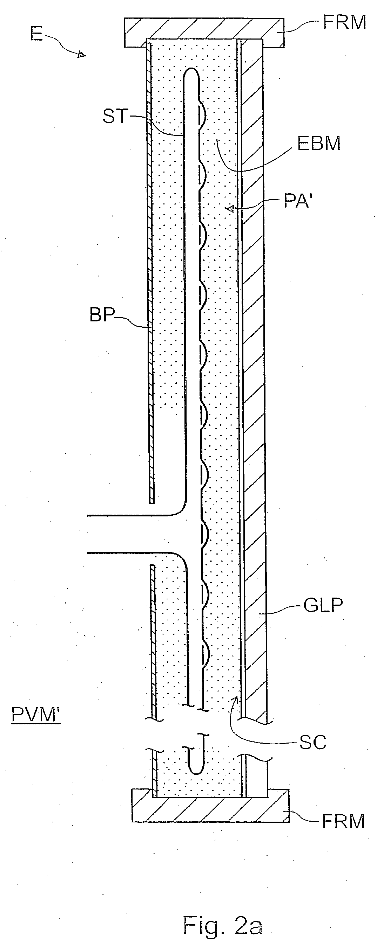

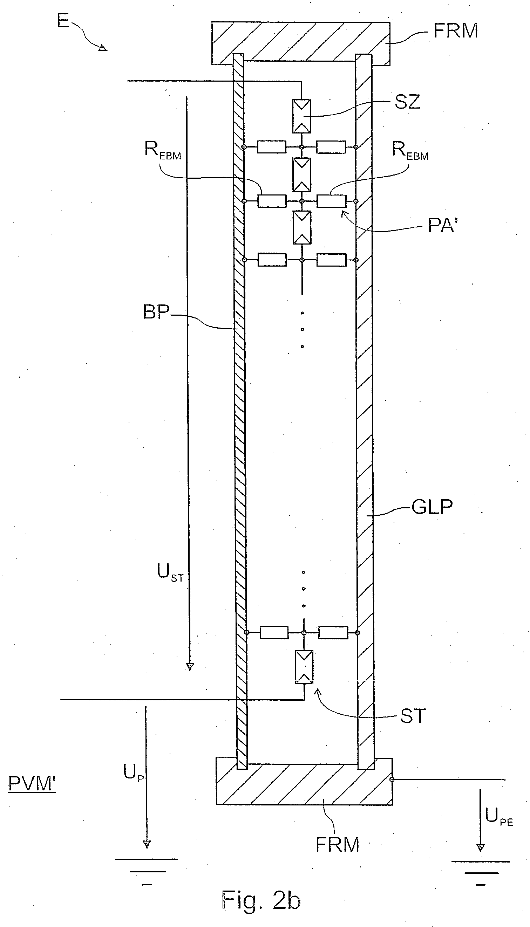

Eine alternative Konstruktion zeigen die Fig. 2a und 2b. Dort wird in die Einfassung bzw. in das Innere des Moduls PVM' ein hochohmig leitendes Einbettmaterial EBM verfüllt, dass einen Potentialausgleich zwischen dem String ST und der Einfassung bestehend aus Rahmen FRM, Glasscheibe GLP und Rückwand BP schafft. Das in der Fig. 2b gezeigte Ersatzschaltbild stellt entsprechende hochohmige Widerstände R_{EBM} dar, die jeweils eine Solarzelle SZ mit der Rückwand BP bzw. der Glasscheibe GLP verbinden. Als Einbettungsmaterial EBM kann z.B. ein hochohmig leitender transparenter Kunststoff verwendet werden.

Bei den anhand der Fig. 2a und 2b dargestellten Ausführungsbeispielen findet ein Potentialausgleich zwischen dem inneren Solarzellen-String ST und der Einfassung statt, so dass die Einfassung und somit auch der Rahmen FRM ein Potentialniveau aufweist, das auf dem mittleren Potentialniveau des Strings ST liegt. Aufgrund des für die Einbettung EBM verwendeten hochohmigen Materialien mit sehr hohen Flächenwiderständen (z.B. **R**' **=** ca. 10E13 Ωcm² mit Rges=R'/Modulfläche) fließen nur sehr schwache Ausgleichsströme, so dass keines der Bauteile oder gar die ganze Konstruktion gefährdet sein könnte.

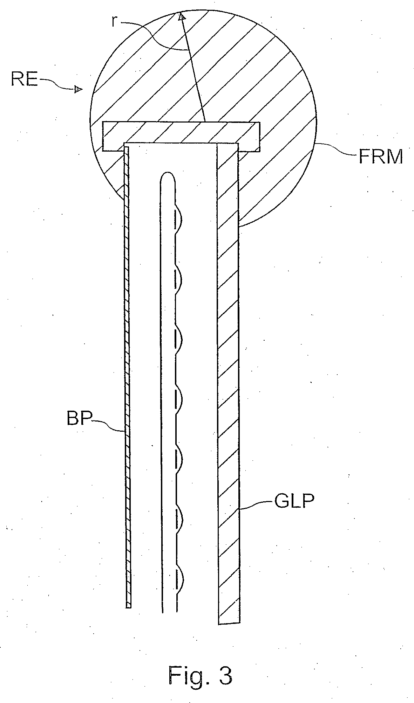

Zusätzlich zu den oben beschriebenen Maßnahmen kann der Rahmen des Moduls selbst gemäß der Figur 3 gestaltet werden, um insbesondere Korona-Entladungen zu verhindern. Hierzu wird der Rahmen FRM einer möglichst keine Spitzen oder Kanten aufweisenden Formgebung unterzogen. Die in der Fig. 3 gezeigte abgerundete Formgebung entspricht einer kreis- bzw. kugelförmigen Gestaltung des Rahmens FRM'. Es sollten vorzugsweise kreisförmige Radien von mindestens r = 3 cm realisiert werden. Der notwendige minimale Radius ist abhängig von der maximalen Spannung auf die Modul aufgeladen wird. Ähnliche Gestaltungen, wie z.B. ein Vieleck mit vielen Seitenflächen, das sich der Form eines Kreises oder einer Kugel annähert, sind auch möglich. Der in der Fig. 3 gezeigte Rahmen FRM der möglichst keine Kanten oder spitz zulaufende Ecken aufweist, sondern durch eine runde bzw. abgerundete (kantenlose) Formgebung geprägt ist. Es sollten vorzugsweise kreisförmige Radien von mindestens r = 3 cm realisiert werden. Die Rundungen sind vorzugsweise asymmetrisch zum Photovoltaik-Modul PVM ausgebildet, so dass der Schwerpunkt bzw. Mittelpunkt des Rahmens FRM z.B. hinter der Modulebene liegt. Dadurch wird eine Abschattung der Modulfläche (Vorderseite) vermieden.

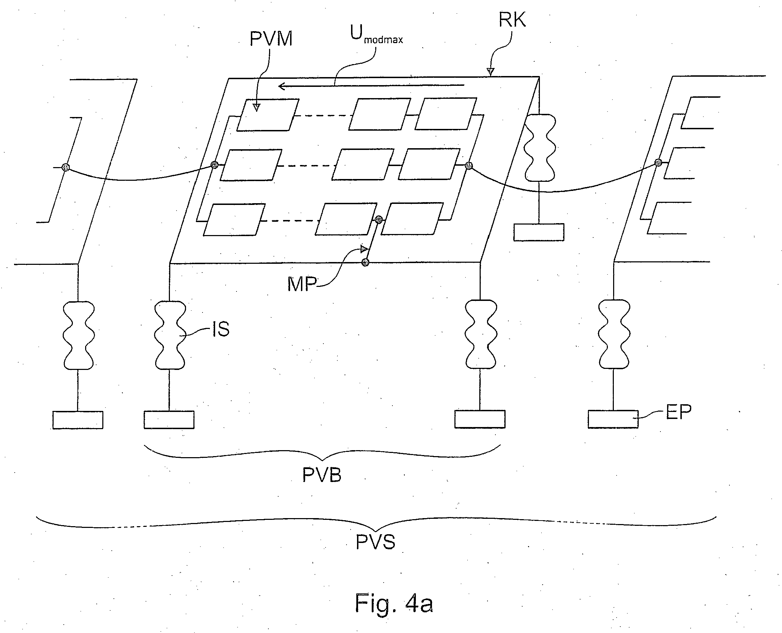

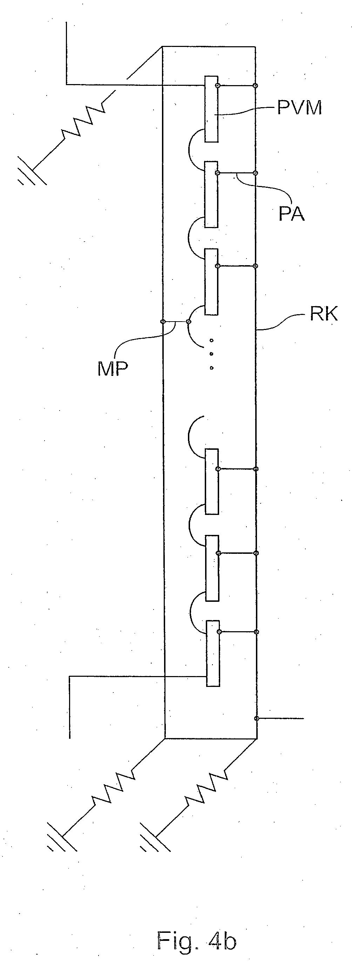

Anhand der Figuren 4a und 4b wird der Aufbau einer Photovoltaik-Einrichtung bzw. -Anlage mit isolierter Modulaufständerung verdeutlicht. Die Einrichtung umfasst mindestens einen aus mehreren PV-Modulen PVM gebildeten PV-Strang PVS, der in der Figur näher im Detail dargestellt ist. Wie dort zu sehen ist, wird für jeden Strang PVS eine Anordnung von mehreren PV-Modulen PVM in Form von Modul-Blöcken PVB vorgeschlagen, die jeweils auf einer gegen Erde isolierten und aufgeständerten Rahmenkonstruktion RK montiert sind. Durch die Isolierung können die PV-Module PVM auf ein sehr hohes elektrisches Potential angehoben werden. Zur Isolierung werden z.B. Keramik- oder Kunststoff-Isolatoren IS eingesetzt.

Durch eine parallele und serielle Verschaltung von jeweils N Modulen PVM je Block PVB und eine vorzugsweise serielle Verschaltung von M Blöcken ergibt sich ein Strang PVS mit insgesamt NxM Modulen.

Durch eine Verschaltung mehrerer solcher PV-Stränge wird schließlich die PV-Anlage bzw. -Einrichtung (nicht dargestellt) gebildet.

Um nun die hier vorgeschlagenen Einfassungen der auf einem PVB montierten Module auf ein Potential zu legen, welches näherungsweise dem Potential der Solarzellen-Strings entspricht, können die zuvor beschriebenen Kontaktelemente (Widerstand, Einbettung) verwendet werden und/oder es kann ein elektrisch leitfähiger Kontakt mit einer elektrisch leitfähig ausgeführten Rahmenkonstruktion RK der Aufständerung über Potentialanbindungen PA (siehe Abb. 4b) hergestellt werden. Das Potential der Rahmenkonstruktion kann dadurch definiert werden, dass diese an einer definierten Stelle, nämlich der Potentialanbindung MP, mit einem Anschlußpunkt der Solarzellenstrings elektrisch leitend verbunden werden (siehe Fig. 4a,b). Somit können im Innern der einzelnen Module PVM keine für Solarzellen oder für das Einbettmaterial schädlichen Feldstärken auftreten.

Alternativ zu einer elektrisch leitfähigen Aufständerung können zusätzliche Potentialausgleichskabel verlegt werden, welche die Einfassungen der Module mit der Potentialanbindung MP verbinden.

### Bezugszeichenliste

- PVM: Photovoltaik-Modul (PV-Modul) mit:
- ST: Solarzellen-Strings (exemplarisch nur jeweils einer dargestellt)
- FRM: Rahmen zur seitlichen Einfassung der Strings ST bzw. zur Umrahmung des PV-Moduls
- GLP: Glasscheibe (vorderseitige Einfassung des Strings ST)
- BP: Rückwand (rückseitige Einfassung des Strings ST)

- R: hochohmig leitendes Element in Gestalt eines diskreten Widerstandes
- EBM: Einbettmaterial, als hochohmig leitendes Element
- SC: hochohmige Beschichtung

- RE: abgerundete Formgebung des Modul-Rahmens FRM
- r: Radius

- PVB: PV-Block (Block aus mehreren PV-Modulen)
- PVS: PV-Strang (Strang aus mehreren PV-Blöcken)
- RK: Rahmenkonstruktion für Modul-Block PVB
- IS: Isolatoren für Aufständerung
- EP: Erdpotential
- PA: Potentialanbindung über diskrete Kontaktierungselemente
- PA': Potentialanbindung über Einbettmaterial

- U_{ST}: Strangspannung
- Up: Spannung zwischen Solarzellenstring und Erdpotential
- U_{PE}: Spannung zwischen Einfassung und Erdpotential

## Patentansprüche

1. Photovoltaik-Modul (PVM) zum Einbau in eine Photovoltaik-Einrichtung, wobei das Photovoltaik-Modul (PVM) mindestens einen Solarzellen-String (ST) aufweist, die jeweils aus einer Anzahl von in Reihe verschalteter Solarzellen bestehen, wobei der mindestens eine Solarzellen-String (ST) in einer aus mehreren Modulteilen (FRM, GLP, BP) gebildeten Einfassung (E) aufgenommen ist, wobei die Modulteile (FRM, GLP, BP) elektrisch leitend ausgebildet und miteinander verbunden sind, so dass die Einfassung (E) eine elektrostatisch wirksame Umhüllung des mindestens einen Solarzellen-Strings (ST) darstellt, und dass die Einfassung (E) mit mindestens einem Kontaktelement (R; EBM) zur Potentialanbindung (PA; PA') der elektrostatisch wirksamen Umhüllung an mindestens ein definiertes elektrisches Potential versehen ist; wobei das mindestens eine Kontaktelement als ein hochohmig leitendes Element (R) mit einem Mindestwiderstand von 10⁶ Ohm ausgebildet ist und/oder aus einem hochohmig leitenden Material (EBM) mit einem Flächenwiderstand von 10⁹ Ohm/cm² gefertigt ist, **dadurch gekennzeichnet, dass** der Rahmen (FRM') des Photovoltaik-Moduls (PVM) eine abgerundete Formgebung aufweist, die asymmetrisch zu dem Photovoltaik-Modul (PVM) ausgebildet ist.

2. Photovoltaik-Modul (PVM) nach Anspruch 1, **dadurch gekennzeichnet, dass** zumindest einzelne der Modulteile (FRM, GLP, BP) elektrisch hochohmig leitend ausgebildet sind

3. Photovoltaik-Modul (PVM) nach Anspruch 1 oder 2, **dadurch gekennzeichnet, dass** eines der Modulteile einem Rahmen (FRM) entspricht, der aus einem Material, insbesondere Metall, gefertigt und/oder mit mindestens einem Element versehen ist, das elektrisch leitend ist.

4. Photovoltaik-Modul (PVM) nach einem der vorhergehenden Ansprüche, **dadurch gekennzeichnet, dass** eines der Modulteile einer Rückwand (BP) entspricht, die aus einem Material gefertigt und/oder mit mindestens einem Element versehen ist, das elektrisch leitend ist.

5. Photovoltaik-Modul (PVM) nach einem der vorhergehenden Ansprüche, **dadurch gekennzeichnet, dass** eines der Modulteile einer Glasscheibe (GLP) entspricht, die mit einem Material versetzt und/oder mit mindestens einem Element (SC) versehen ist, das elektrisch leitend ist.

6. Photovoltaik-Modul (PVM) nach einem der Ansprüche 3 bis 5, **dadurch gekennzeichnet, dass** das mindestens eine elektrisch leitende Element einer zumindest hochohmig leitenden Beschichtung (SC) entspricht.

7. Photovoltaik-Modul (PVM) nach Anspruch 6, **dadurch gekennzeichnet, dass** die Beschichtung (SC) auf einem der Modulteile (GLP; BP) streifenförmig oder gitterförmig aufgetragen ist.

8. Photovoltaik-Modul (PVM) nach einem der vorhergehenden Ansprüche, **dadurch gekennzeichnet, dass** das mindestens eine Kontaktelement als ein zumindest hochohmig leitender Kontaktpunkt ausgebildet ist, der an einem der Modulteile (FRM) angeordnet ist.

9. Photovoltaik-Modul (PVM) nach Anspruch 1, **dadurch gekennzeichnet, dass** das mindestens eine Kontaktelement als hochohmig leitender Widerstand (R) ausgebildet ist.

10. Photovoltaik-Modul (PVM) nach Anspruch 9, **dadurch gekennzeichnet, dass** der mindestens eine Solarzellen-String (ST) über den hochohmig leitenden Widerstand (R) mit der Einfassung (E), insbesondere mit dem Rahmen (FRM), elektrisch verbunden ist.

11. Photovoltaik-Modul (PVM) nach Anspruch 1, **dadurch gekennzeichnet, dass** das hochohmig leitende Material als ein in die Einfassung (E) eingebrachtes Einbettungsmaterial (EBM) ausgebildet ist, wobei der mindestens eine Solarzellen-String (ST) innerhalb der Einfassung (E) in dem Einbettungsmaterial (EBM) aufgenommen ist.

12. Photovoltaik-Modul (PVM) nach einem der Ansprüche 3 bis 11, **dadurch gekennzeichnet, dass** die abgerundete Formgebung eine kreis- bzw. kugelförmige Gestaltung aufweist.

13. Photovoltaik-Modul (PVM) nach Anspruch 12, **dadurch gekennzeichnet, dass** die abgerundete Formgebung des Rahmens (FRM') asymmetrisch zum Photovoltaik-Modul (PVM) so ausgebildet ist, dass der Schwerpunkt und/oder Mittelpunkt des Rahmens (FRM') außerhalb bzw. vor oder hinter der Modulebene liegt.

14. Photovoltaik-Einrichtung mit mehreren Photovoltalk-Modulen (PVM), wobei jedes Photovoltaik-Modul (PVM) eine Anordnung mindestens eines Solarzellen-Strings (ST) aufweist, der aus einer Anzahl von in Reihe verschalteter Solarzellen (SZ) besteht, wobei der mindestens eine Solarzellen-String (ST) in einer aus mehreren Modulteilen (FRM, GLP, BP) gebildeten Einfassung (E) aufgenommen ist, wobei die Modulteile (FRM, GLP, BP) elektrisch leitend ausgebildet und miteinander verbunden sind, so dass die Einfassung (E) eine elektrostatisch wirksame Umhüllung des mindestens einen Solarzellen-Strings (ST) darstellt, und dass die Einfassung (E) mit mindestens einem Kontaktelement (R; EBM) zur Potentialanbindung (PA; PA') der elektrostatisch wirksamen Umhüllung an mindestens ein definiertes elektrisches Potential versehen istwobei das mindestens eine Kontaktelement als ein hochohmig leitendes Element (R) mit einem Mindestwiderstand von 10⁶ Ohm ausgebildet ist und/oder aus einem hochohmig leitenden Material (EBM) mit einem Mindestflächenwiderstand von 10⁹ Ohm/cm² gefertigt ist, **dadurch gekennzeichnet, dass** der Rahmen (FRM') des Photovoltaik-Moduls (PVM) eine abgerundete Formgebung aufweist, die asymmetrisch zu dem Photovoltaik-Modul (PVM) ausgebildet ist.

15. Photovoltaik-Einrichtung nach Anspruch 14, **dadurch gekennzeichnet, dass** die mehreren Photovoltaik-Module (PVM) in einer, insbesondere isoliert aufgeständerten, Rahmenkonstruktion (RK) montiert sind, wobei jeweils die Einfassung (E) eines Photovoltaik-Moduls (PVM) über das mindestens eine Kontaktelement eine Potentialanbindung (PA) an die Rahmenkonstruktion (RK) aufweist.

16. Photovoltaik-Einrichtung nach Anspruch 14 oder 15, **dadurch gekennzeichnet, dass** die Rahmenkonstruktion (RK) mit einer Potentialanbindung (MP) versehen ist, die zumindest mit einer Einfassung (E) der Photovoltaik-Modul (PVM) verbunden ist.

## Claims

1. Photovoltaic module (PVM) for installation in a photovoltaic device, the photovoltaic module (PVM) comprising at least one solar cell string (ST), each consisting of a number of interconnected solar cells in series, wherein the at least one solar cell string (ST) is accomodated in an encasement (E) consisting of several module parts (FRM, GLP, BP), wherein the module parts (FRM, GLP, BP) are electrically conductive and are connected to one another and are formed so that the encasement (E) constitutes an electrostatically effective encasement for the at least one solar cell string (ST), and that the encasement (E) comprises at least one contact element (R; EBM) for providing a grounding contact (PA, PA ') for the electrostatically effective encasement via a connection with at least one defined electrical potential; wherein the at least one contact element (R; EBM) is designed as an electrically conductive element (R) with high resistance having a minimum resistance of 10⁶ Ohm and/or being made of an electrically conductive material (EBM) with high resistance having a surface resistivity of at least 10⁹ Ohm/cm², **characterized in that** the frame (FRM') of the photovoltaic module (PVM) has a rounded shape which is formed asymmetrically with respect to the photovoltaic module (PVM).

2. The photovoltaic module (PVM) according to claim 1, **characterized in that** at least some of the module parts (FRM, GLP, BP) are designed to be electrically conductive with high resistance.

3. The photovoltaic module (PVM) according to claim 1 or 2, **characterized in that** one of the module parts corresponds to a frame (FRM), which is made of a material, in particular made of metal and / or provided with at least one element which is electrically conductive.

4. The photovoltaic module (PVM) according to one of the preceding claims, **characterized in that** one of the module parts corresponds to a rear panel (BP) which is made of a material and / or is provided with at least one element which is electrically conductive.

5. The photovoltaic module (PVM) according to one of the preceding claims, **characterized in that** one of the module parts corresponds to a glass pane (GLP) which is provided with a material and / or with at least one element (SC) being electrically conductive.

6. The photovoltaic module (PVM) according to one of claims 3 to 5, **characterized in that** the at least one electrically conductive element corresponds to at least one high resistance conductive coating (SC).

7. The photovoltaic module (PVM) according to claim 6, **characterized in that** the coating (SC) is applied to one of the module parts (GLP; BP) in a shape of strips or a grid.

8. The photovoltaic module (PVM) according to one of the preceding claims, **characterized in that** the at least one contact element is designed as a contact point being electrically conductive with high resistance and being attached to one of the module parts (FRM).

9. The photovoltaic module (PVM) according to one of claim 1, **characterized in that** the at least one contact element is designed as a high resistance conductive resistor (R).

10. The photovoltaic module (PVM) according to claim 9, **characterized in that** the at least one solar cell string (ST) is electrically connected with the encasement (E), and in particular with the frame (FRM), via the high resistance conductive resistor (R).

11. The photovoltaic module (PVM) according to claim 1, **characterized in that** the high-resistance conductive material is designed as an embedded material (EBM) being introduced into the encasement (E), wherein the at least one solar cell string (ST) is accomodated in the embedding material (EBM) within the encasement (E).

12. The photovoltaic module (PVM) according to one of claims 3 to 11, **characterized in that** the rounded shape comprises a round or spherical design.

13. The photovoltaic module (PVM) according to claim 12, **characterized in that** the rounded shap of the frame (FRM ') is formed asymmetrically with respect to the photovoltaic module (PVM) such that the center of mass and / or the center point of the frame (FRM') is outside or in front of or behind the module plane.

14. Photovoltaic device comprising a plurality of photovoltaic modules (PVM), each photovoltaic module (PVM) comprising an arrangement of at least one solar cell string (ST) consisting of a number of solar cells (SZ) being interconnected in series, wherein at least one solar cell string (ST) is accomodated in an encasement (E) consisting of several module parts (FRM, GLP, BP), wherein the module parts (FRM, GLP, BP) are electrically conductive and are connected to one another and are formed so that the encasement (E) constituites an electrostatically effective encasement for the at least one solar cell string (ST), and that the encasement (E) comprises at least one contact element (R; EBM) for providing a grounding contact (PA, PA ') for the electrostatically effective encasement via a connection with at least one defined electrical potential; wherein the at least one contact element (R; EBM) is designed as an electrically conductive element (R) with high resistance having a minimum resistance of 10⁶ Ohm and/or being made of an electrically conductive material (EBM) with high resistance having a surface resistivity of at least 10⁹ Ohm/cm², **characterized in that** the frame (FRM') of the photovoltaic module (PVM) has a rounded shape which is formed asymmetrically with respect to the photovoltaic module (PVM).

15. The photovoltaic device according to claim 14, **characterized in that** the plurality of photovoltaic modules (PVM) are mounted in a frame construction (RK) which in particular is isolated and elevated, wherein each encasement (E) of a photovoltaic module (PVM) comprises a grounding contact (PA) via the at least one contact element to the frame construction (RK).

16. The photovoltaic device according to claim 14 or 15, **characterized in that** the frame construction (RK) comprises a potential connection (MP) which is connected to at least one encasement (E) of the photovoltaic module (PVM).

## Revendications

1. Un module photovoltaïque (PVM) pour une installation au sein d'un dispositif photovoltaïque, le module photovoltaïque (PVM) comprenant au moins une chaîne de cellules solaires (ST), chacune consistant en un nombre de cellules solaires interconnectées en série, dans lequel la chaîne de cellules solaires au moins (ST) est disposée à l'intérieur d'un emboîtage (E) consistant en plusieurs parties de modules (FRM, GLP, BP), dans lequel les parties de modules (FRM, GLP, BP) sont conductrices électriquement et sont connectées l'un à l'autre et formés de telle manière que l'emboîtage (E) constitue un emboîtage électrostatique efficace pour la chaîne de cellules solaires au moins (ST) ; et en ce que l'emboîtage (E) comporte au moins un élément de contact (R ; EBM) pour fournir un contact de terre (PA, PA') pour l'emboîtage électrostatique efficace via une connexion avec au moins un potentiel électrique défini ; dans lequel l'élément de contact au moins (R ; EBM) est conçu comme un élément électriquement conducteur (R) ayant une résistance élevée avec une résistance minimale de 10⁶ Ohms et/ou étant réalisé en un matériau électriquement conducteur (EBM) ayant une résistance élevée avec une résistivité de surface égale à au moins 10⁹ Ohm/cm², **caractérisé en ce que** le cadre (FRM') du module photovoltaïque (PVM) présente une forme arrondie qui est asymétrique par rapport au module photovoltaïque (PVM).

2. Le module photovoltaïque (PVM) selon la revendication 1, **caractérisé en ce que** au moins certaines parties des parties de modules (FRM, GLP, BP) sont conçues pour être électriquement conducteurs avec une haute résistance.

3. Le module photovoltaïque (PVM) selon la revendication 1 ou 2, **caractérisé en ce qu'**une des parties de module correspond au cadre (FRM), réalisé en matériau, en particulier en métal et/ou fourni avec au moins un élément qui est électriquement conducteur.

4. Le module photovoltaïque (PVM) selon l'une quelconque des revendications précédentes, **caractérisé en ce que** l'une des parties de module correspond à un panneau arrière (BP) qui est réalisé en un matériau et/ou fourni au moins avec un élément qui est électriquement conducteur.

5. Le module photovoltaïque (PVM) selon l'une quelconque des revendications précédentes ; **caractérisé en ce que** l'une des parties de module correspond à une plaque de verre (GLP) qui est fournie avec un matériau et/ou au moins un élément (SC) qui est électriquement conducteur.

6. Le module photovoltaïque (PVM) selon l'une des revendications 3 à 5, **caractérisé en ce que** le ou les élément(s) électriquement conducteur(s) correspond(ent) à au moins un recouvrement conducteur à haute résistance.

7. Le module photovoltaïque (PVM) selon la revendication 6, **caractérisé en ce que** le revêtement (SC) est appliqué à l'une des parties de module (GLP ; BP) sous la forme de bandes ou de maillage.

8. Le module photovoltaïque (PVM) selon l'une des revendications précédentes, **caractérisé en ce que** le ou les élément(s) de contact est/sont conçu(s) sous la forme d'un point de contact qui est électriquement conducteur avec une résistance élevée et qui est fixée à l'une des parties de module (FRM).

9. Le module photovoltaïque (PVM) selon la revendication 1, **caractérisé en ce que** le ou les élément(s) de contact est/sont conçu(s) sous la forme d'une résistance conductrice de valeur (R) élevée.

10. Le module photovoltaïque (PVM) selon la revendication 9, **caractérisé en ce que** la chaîne de cellules solaires au moins (ST) est électriquement connectée à l'emboîtage (E), et en particulier avec le cadre (FRM), via une résistance (R) conductrice de valeur élevée.

11. Le module photovoltaïque (PVM) selon la revendication 1, **caractérisé en ce que** le matériau conducteur de résistance élevée est réalisé au moyen d'un matériau enrobé (EBM) qui est introduit à l'intérieur de l'emboîtage (E), dans lequel la chaîne de cellules solaires au moins (ST) est disposée avec le matériau enrobé (EBM) à l'intérieur de l'emboîtage (E).

12. Le module photovoltaïque (PVM) selon l'une quelconque des revendications 3 à 11, **caractérisé en ce que** la forme arrondie est ronde ou sphérique.

13. Le module photovoltaïque (PVM) selon la revendication 12, **caractérisé en ce que** la forme arrondie du cadre (FRM') est formée asymétriquement relativement au module photovoltaïque (PVM) de telle manière que le centre des masses et/ou le point central du cadre (FRM') est à l'extérieur ou à l'avant ou à l'arrière du plan du module.

14. Un dispositif photovoltaïque comprenant une pluralité de modules photovoltaïques (PVM), chaque module photovoltaïque (PVM) comprenant une disposition d'au moins une chaîne de cellules solaires (ST) consistant en un nombre de cellules solaires (SZ) interconnectées en série, dans lequel au moins une des chaîne de cellules solaires (ST) est disposée à l'intérieur d'un emboîtage (E) consistant en plusieurs parties de modules (FRM, GLP, BP), dans lequel lès parties de modules (FRM, GLP, BP) sont conductrices électriquement et sont connectées l'un à l'autre et formés de telle manière que l'emboîtage (E) constitue un emboîtage électrostatique efficace pour la chaîne de cellules solaires au moins (ST) ; et en ce que l'emboîtage (E) comporte au moins un élément de contact (R ; EBM) pour fournir un contact de terre (PA, PA') pour l'emboîtage électrostatique efficace via une connexion avec au moins un potentiel électrique défini ; dans lequel l'élément de contact au moins (R ; EBM) est conçu comme un élément électriquement conducteur (R) ayant une résistance élevée avec une résistance minimale de 10⁶ Ohms et/ou étant réalisé en un matériau électriquement conducteur (EBM) ayant une résistance élevée avec une résistivité de surface égale à au moins 10⁹ Ohm/cm², **caractérisé en ce que** le cadre (FRM') du module photovoltaïque (PVM) présente une forme arrondie qui est asymétrique par rapport au module photovoltaïque (PVM).

15. Le dispositif photovoltaïque selon la revendication 14, **caractérisé en ce que** la pluralité de modules photovoltaïques (PVM) sont montées dans une structure de cadre (RK) qui en particulier est isolée et élevée, dans laquelle un emboîtage (E) d'un module photovoltaïque (PVM) comporte un contact de terre (PA) pour la structure de cadre (RK) via l'élément de contact au moins.

16. Le dispositif photovoltaïque selon la revendication 14 ou 15, **caractérisé en ce que** la structure de cadre (RK) comporte une connexion de potentiel (MP) qui est connectée à l'emboîtement au moins du module photovoltaïque (PVM).
